Europäisches Patentamt

European Patent Office

Office européen des brevets

(11) Publication number: **0 189 309 B1**

(12) **EUROPEAN PATENT SPECIFICATION**

(45) Date of publication of patent specification: **22.07.92**

(21) Application number: **86300388.5**

(22) Date of filing: **21.01.86**

(51) Int. Cl.⁵: **H01L 21/316**, C30B 23/02, C30B 29/22

(54) Semiconductor device and method of producing same by molecular beam epitaxy.

(30) Priority: **21.01.85 JP 9607/85**

(43) Date of publication of application:
**30.07.86 Bulletin 86/31**

(45) Publication of the grant of the patent:
**22.07.92 Bulletin 92/30**

(84) Designated Contracting States:
**DE FR GB**

(56) References cited:
**EP-A- 0 107 325**

(73) Proprietor: **SANYO ELECTRIC CO., LTD.**
**18, Keihanhondori 2-chome**
**Moriguchi-shi Osaka-fu(JP)**

(72) Inventor: **Nonaka, Hideyuki**
**9-46-402, Ueno 2-Chome**
**Hirakata-Shi Osaka-Fu(JP)**

(74) Representative: **Laredo, Jack Joseph et al**
**Elkington and Fife Prospect House 8 Pembroke Road**
**Sevenoaks, Kent TN13 1XR(GB)**

**Description**

BACKGROUND OF THE INVENTION

Field of the Invention

The present invention relates to a semiconductor device and a method of producing same, in particular semiconductor device comprising a single crystalline silicon substrate provided with single crystalline films of oxides such as $Al_2O_3$, MgO and $MgO.Al_2O_3$ laminated thereon and a method of producing same by Molecular Beam Epitaxy.

Description of the Prior Art

Semiconductor device comprising a single crystalline silicon substrate provided with interlayer insulating films and silicon layers being alternatively laminated thereon and a circuit structure being incorporated therein have been developed. Metal oxides such as $Al_2O_3$, MgO and $MgO \cdot Al_2O_3$ have been used as the interlayer insulating films of such a semiconductor device, but these interlayer insulating films have been formed on the silicon substrate and each silicon layer usually by CVD (Chemical Vapor Deposition) in the form of single crystal, poly crystal or amorphous substance.

However, high temperatures at about 1,000°C have been necessary in the formation of said insulating films of oxides such as $MgO \cdot Al_2O_3$ by CVD. Accordingly, each silicon layer and the silicon substrate have been exposed to high temperatures by every CVD in the process of forming lamination of silicon layers and a plurality of interlayer insulating films on the silicon substrate by CVD, thereby there has been possibility that the silicon substrate and each silicon layer or elements which are being formed are damaged by the thermal shock due to CVD. In addition, it has been difficult to control the film thickness by CVD. That is to say, a problem has occurred in difficulty to obtain the desired film thickness.

In respect of such a problem in CVD, the formation of the above described interlayer insulating films of oxide by MBE (Molecular Beam Epitaxy), in which thin films can be formed at lower temperatures such as 700°C ~ 800°C, has been tried. Since MBE is carried out under ultra-high vacuum, it is easy to control the thickness of films and the films can be formed at temperatures lower than those in CVD. Accordingly, MBE has an advantage in that the silicon substrate, each silicon layer and the like is hardly influenced by heat and thus, the use of MBE for the formation of films in semiconductor devices and the like has been widely investigated.

The formation of insulating films of oxides such as $MgO \cdot Al_2O_3$ by MBE is reported by, for example, R. A. Stall in p. 135 ~ 137, J. Vac. Sci. Technol., B1(2), Apr.-June (1983), that is to say "Growth of refractory oxide film using solid oxygen sources in a molecular beam epitaxy apparatus" is reported.

Reference should also be made to EP-A-010735 which describes a method of fabricating an oxide film $R_mO_n$, where R is at least one metal or at least one semiconductor, or combination thereof, and m and n are integers, characterised by (a) mounting a substrate in a chamber, (b) providing in the chamber a solid oxygen source, which does not contain R, (c) providing a source of R in the chamber, and (d) heating the sources to evaporation, the evaporants reacting to form the oxide film $R_mO_n$ on the substrate. Using the technique of molecular beam epitaxy (MBE) involving an ultra-high vacuum, films of $Al_2O_3$, MgO, $SiO_2$ and $MgAl_2O_4$ ($MgO \cdot Al_2O_3$) were grown using $As_2O_3$ or $Sb_2O_3$ as the oxygen source.

A certain extent of result is reported on the formation of films not on a Si substrate but on a GaAs substrate. It is, however, the actual state that the formation of oxides such as $MgO \cdot Al_2O_3$ to be laminated on a silicon layer in the form of poly crystalline oxide film, or single crystalline oxide film as in above-mentioned semiconductor device of multi-layer structure has never been achieved. In addition, a problem has occurred in that also a $MgO \cdot Al_2O_3$ film must be single crystalline in case that a single crystalline silicon layer is further laminated on the insulating film of $MgO \cdot Al_2O_3$ and the like formed on a single crystalline silicon substrate. That is to say, when elements are formed in poly crystalline or amorphous silicon layer, they do not exhibit the reproductivity as an electronic circuit (since a poly crystalline or amorphous layer cannot reproduce identical characteristics, circuits having identical characteristics cannot be obtained even though elements having identical circuit patterns are formed in them) and also electric characteristics become nonuniform thereby electronic characteristics of electronic circuit as designed cannot be obtained. Accordingly, a method, in which a silicon layer grown on an insulating film is once melted by a laser beam and the like and then recrystallized to obtain a single crystalline layer, has been tried. However, this method has the problems in that the crystal seed in recrystallization must be only one in order to obtain a single crystal and accordingly, the temperature distribution must be controlled and the crystal must be grown only in the appointed direction from the seed.

OBJECT OF THE INVENTION

It is a first object of the present invention to provide a semiconductor device comprising a single crystalline substrate provided with an insulating film of oxides formed thereon by MBE and a method of producing same.

It is a second object of the present invention to provide a method of producing a semiconductor device, in which the thermal shock to a silicon substrate and elements formed therein can be prevented when insulating film is formed on a single crystalline substrate, and the semiconductor device produced by said method.

It is a third object of the present invention to provide a method of producing a semiconductor device, in which a single crystalline insulating film of oxides can be formed on a single crystalline silicon substrate by the molecular beam epitaxy (MBE) technique and the semiconductor device produced by this method.

SUMMARY OF THE INVENTION

The invention consists in a method of producing a semiconductor device, in which an oxide film formed by oxidizing metal atoms with one or more group V metal oxides as an oxygen source is grown on a single crystalline silicon substrate by the Molecular Beam Epitaxy (MBE) technique, said oxide film being composed of a material selected from the group consisting of $MgO \cdot Al_2O_3$, $MgO$ and $Al_2O_3$, characterised in that (1) the temperature of said single crystalline silicon substrate is set within the range of from $700°C$ to $900°C$, said temperature being in the range of from $800°C$ to $900°C$ for an oxide film of $MgO \cdot Al_2O_3$; from $700°C$ to $900°C$ for an oxide film of $MgO$; and $750°C$ to $900°C$ for an oxide film of $Al_2O_3$, (2) the ratio of the number of oxygen atoms to the number of metal atoms of the oxide film is set in the range of from 2:1 to 4:1, and (3) the crystal growth speed is set in the range of from $0.1\mu m/hour$ to $2.0\mu m/hour$, whereby said oxide film is grown in a single crystalline form.

In a preferred embodiment, layers of the oxide film and layers of the silicon substrate material are alternately laminated onto the silicon substrate to form a three-dimensional circuit structure in which all of the layers are of a single crystalline form.

The above and further objects and features of the invention will be more fully apparent from the following detailed description with reference to the accompanying drawings.

BRIEF DESCRIPTION OF THE DRAWINGS

FIG. 1 is a schematic sectional view showing an construction of semiconductor device according to the present invention;

FIG. 2 is a schematic side sectional view showing a MBE (Molecular Beam Epitaxy) apparatus for carrying out a method of producing semiconductor devices according to the present invention;

FIG. 3 is a schematic drawing showing the reactions making progress when $MgO \cdot Al_2O_3$ is deposited on a single crystalline silicon substrate;

FIGS. 4-1 to 3 are RHEED patterns showing the crystallinity of $MgO \cdot Al_2O_3$ in dependence upon substrate temperatures in case where $Sb_2O_3$ is used as an oxygen source;

FIGS. 5-1 to 3 are RHEED patterns showing the crystallinity of $MgO \cdot Al_2O_3$ in dependence upon substrate temperatures in case where $As_2O_3$ is used as an oxygen source;

FIGS. 6-1 to 3 are RHEED patterns showing the crystallinity of $MgO \cdot Al_2O_3$ in dependence upon a number of oxygen atoms supplied in case where $Sb_2O_3$ is used as an oxygen source; and

FIGS. 7-1 to 3 are RHEED patterns showing the crystallinity of $MgO.Al_2O_3$ in dependence upon a number of oxygen atoms supplied in case where $As_2O_3$ is used as an oxygen source.

DETAILED DESCRIPTION OF THE INVENTION

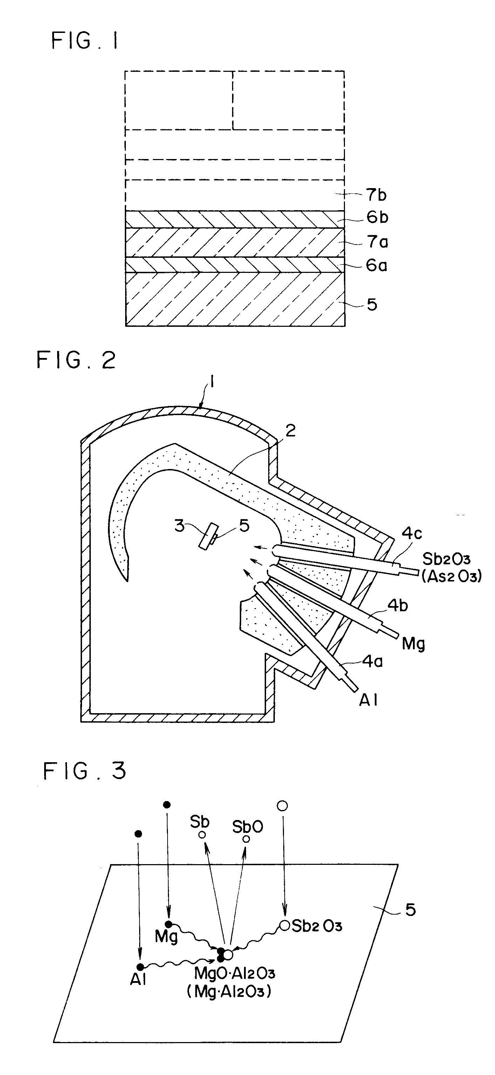

Referring now to FIG. 1 which is a sectional view showing a construction of a semiconductor device according to the present invention, interlayer insulating films 6a, 6b ... and silicon layers 7a, 7b ... are alternatively laminated on a single crystalline silicon substrate 5 to form a three dimensional circuit structure, that is to say, an interlayer insulating film 6a, which is an oxide film, is laminated on the single crystalline silicon substrate 5, a silicon layer 7a being laminated on the interlayer insulating film 6a, an interlayer insulating film 6b being laminated on the silicon layer 7a, a silicon layer 7b being laminated on the interlayer insulating film 6b .....

The interlayer insulating film 6a laminated on the single crystalline silicon substrate 5 and the interlayer insulating films 6b ... arranged thereover are formed as single crystalline layers and also each of the silicon layers 7a, 7b ... is formed as a single crystalline layer.

FIG. 2 is a schematic side sectional view of an MBE apparatus for carrying out a method of producing a semiconductor device according to the present invention and FIG. 3 is a schematic drawing showing the reactions making progress when $MgO \cdot Al_2O_3$ (magnesia spinel) is deposited on a single crystalline silicon substrate 5.

Referring to FIGS. 2, 3, referring numeral 1 designates an ultra-high vacuum vessel and 2 designates a cryoshroud disposed in the ultra-high vacuum vessel 1 and filled with liquid nitrogen.

A sample-heating plate 3 provided therein with a heater (not shown) is installed within a space surrounded by the cryoshroud 2 and the single crystalline silicon substrate 5 is fixedly mounted on the surface of the sample-heating plate 3, concretely its surface being opposite to effusing cells 4a, 4b, 4c which are described later.

The effusing cells 4a, 4b, 4c aim at supplying molecules of Al, Mg, and $Sb_2O_3$ respectively, and pass through the cryoshroud 2 so as to direct the front ends thereof toward the single crystalline silicon substrate 5 fixedly mounted on the sample-heating plate 3, respectively. Al is housed in the effusing cell 4a, Mg in the effusing cell 4b, and the group V oxides as an oxygen source, for example $Sb_2O_3$ (also $As_2O_3$ and the like can be used), in the effusing cell 4c. These effusing cells 4a, 4b, 4c are constructed so that upon heating at the appointed temperatures, molecules of substances housed therein may be directed from the front ends thereof toward the silicon substrate 5 at the appointed speeds.

The silicon substrate 5 is heated at the appointed temperature. In case where Al molecules and $Sb_2O_3$ molecules are supplied into the cryoshroud 2, the reaction expressed by the following equation (1) makes progress thereby forming a single crystalline, poly crystalline or amorphous layer of $Al_2O_3$ which is an insulating oxide film, and gradually making the layer grow:

$$2Al \; + \; Sb_2O_3 \; \rightarrow \; Al_2O_3 \; + \; 2Sb\uparrow \qquad (1)$$

The formation of other insulating oxide films of MgO, $MgO \cdot Al_2O_3$ or the like is fundamentally similar. That is to say, the reactions expressed by the following equation (2) and (3) make progress by supplying Mg molecules and $Sb_2O_3$ molecules or Mg molecules, Al molecules and $Sb_2O_3$ molecules, respectively, thereby forming a single crystalline, poly crystalline or amorphous layer and gradually making the formed layer grow:

$$3Mg \; + \; Sb_2O_3 \; \rightarrow \; 3MgO \; + \; 2Sb\uparrow \qquad (2)$$

$$6Al \; + \; 3Mg \; + \; 4Sb_2O_3 \; \rightarrow \; 3MgO \cdot Al_2O_3 \; + \; 8Sb\uparrow \qquad (3)$$

FIG. 3 shows the reaction process expressed by the above described equation (3).

It is suitable that oxide films to be formed as the insulating films 6a, 6b ... are formed of the above described $MgO \cdot Al_2O_3$ (magnesia spinel), $Al_2O_3$, MgO or the like. The reason is that crystal forms of the oxide films are cubic being identical with that of a single silicon crystal of the substrate, and the formers are similar to the latter in lattice constant thereby the oxide films are easy to epitaxially grow.

Though $Al_2O_3$ usually having a hexagonal crystal form, $\gamma$-type one has a cubic crystal form in a stabilized range of 900°C or less, it can be used.

Although $Sb_2O_3$ is used as an oxygen source in the present invention, the oxygen source is not limited to the use of $Sb_2O_3$. As disclosed in the above described report by R. A. Stall, also other group V oxides can be used.

The reason why the group V oxides are preferably used as an oxygen source is that the group V elements, above all Sb, have a lower sticking coefficient thereby their linkage with oxygens is easy to cancel, and they are difficult to link with Si atoms constructing the silicon substrate 5. In other words, the reason why the group V oxides, above all an oxide of Sb (for example $Sb_2O_3$), are used as an oxygen source is that not only the vacuum condition within the ultra-high vacuum vessel 1 is hardly dropped but also impurities can be prevented from depositing to the silicon substrate 5.

Still, it is unsuitable to use oxygen itself as an oxygen source since the vacuum condition within the ultra-high vacuum vessel 1 is dropped.

On the other hand, it is almost uniquely determined by the growing conditions whether insulating oxide films are formed in the form of a single crystalline, a poly crystalline or an amorphous layer on the silicon substrate 5. The present inventor found it from various kinds of experiments that the conditions as shown in the following Tables 1, 2 are required for growing oxide films, such as $Al_2O_3$, MgO and $MgO \cdot Al_2O_3$, on the silicon substrate 5 in the form of single crystalline layer by MBE:

In the following Tables 1, 2 the conditions required for forming single crystalline oxide films on a (100) plane of the single crystalline silicon substrate are shown.

Table 1

|  | Substrate Temperature (°C) | Al cell Temperature (°C) | Mg cell Temperature (°C) | $Sb_2O_3$ Pressure Pa (Torr) |
|---|---|---|---|---|
| $Al_2O_3$ | 750 or more | 1110 | - | $2.7 \times 10^{-6}$ $(2.0 \times 10^{-8})$ |
| MgO | 700 or more | - | 550 | $2.7 \times 10^{-5}$ $(2.0 \times 10^{-7})$ |
| $MgO \cdot Al_2O_3$ | 800 or more | 1100 | 350 | $3.3 \times 10^{-6}$ $(2.5 \times 10^{-8})$ |

Table 2

|  | Ratio of Atom Number | Growth Speed ($\mu$m/hour) |
|---|---|---|
| $Al_2O_3$ | O/Al : 2 ~ 4 | 0.1 ~ 2.0 |
| MgO | O/Mg : 2 ~ 4 | 0.1 ~ 2.0 |
| $MgO \cdot Al_2O_3$ | O/Mg + Al : 2 ~ 4 | 0.1 ~ 2.0 |

Among the above described conditions, the especially important conditions for obtaining single crystalline oxide films are (1) the substrate temperature, (2) the ratio of atom numbers, (3) the film growth speed and the like. And, as far as these three conditions and other incidental conditions are satisfied, the oxide film, which can be deemed as an almost single crystalline layer, can be laminated on a single crystalline silicon substrate, even though a slight quantity of poly crystalline portion is contained in the single crystalline layer. Each of these conditions will be below described.

(1) Substrate temperature

In case where a substrate temperature, that is a temperature of a surface, on which an insulating oxide film 6a is formed, of a silicon substrate 5 is a certain extent of temperature or more, molecules of an oxide film substance, such as $Al_2O_3$, have the momentum of high level thereby not depositing to the surface of the silicon substrate 5. On the other hand, in case where the substrate temperature is a certain extent of temperature or less, plenty of molecules are deposited thereby growing a poly crystalline layer. In case where the substrate temperature is further lower, an amorphous layer is formed. Also in MBE, as same as in CVD, there is the possibility that a silicon substrate is damaged by the thermal shock, so it is necessary that the substrate temperature is a certain temperature, concretely about 900°C, or less in order to protect the silicon substrate 5 and semiconductor elements formed on the silicon substrate 5.

On the basis of the above described premise, the substrate temperature of 750°C or more (but 900°C or less) is required in order to form an insulating single crystalline oxide film formed of $Al_2O_3$ on a single crystalline silicon substrate. In case where the substrate temperature is below 700°C, a poly crystalline layer is formed, and in case where the substrate temperature is further lower, an amorphous layer is formed.

Similarly, as to MgO, a single crystalline film is formed at the substrate temperature of 700°C or more (but 900°C or less), a poly crystalline film at temperatures below 700°C, and an amorphous film at further lower temperatures.

Further, as to $MgO \cdot Al_2O_3$, a single crystalline film is formed at the substrate temperature of 800°C or more (but 900°C or less), a poly crystalline film at temperatures below 800°C, and an amorphous film at further lower temperatures.

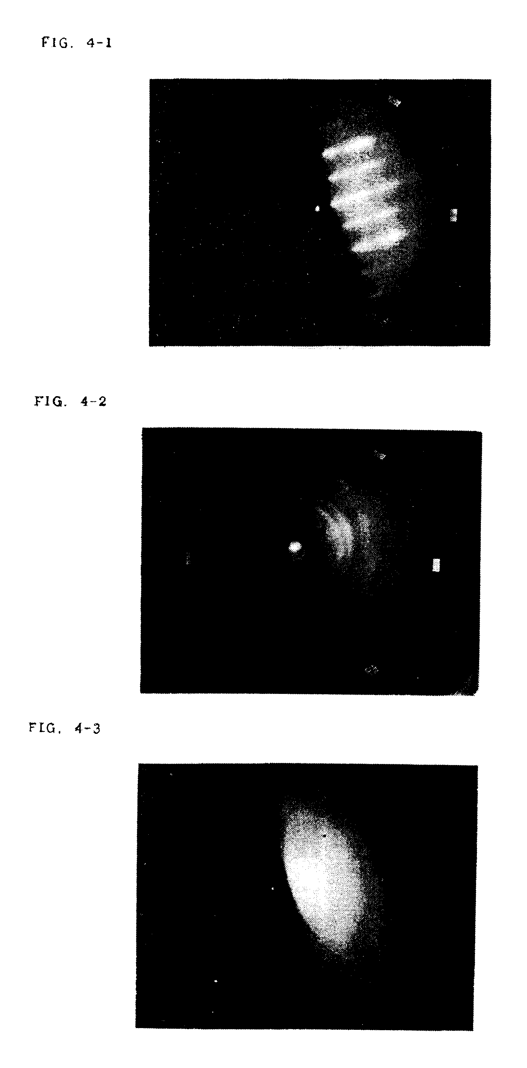

RHEED (Reflection High Energy Electron Diffraction) patterns as shown in FIGS. 4-1 to 3 show the differences in crystallinity depending upon the above described substrate temperatures. Concretely speaking, this is a case where the crystals of $MgO \cdot Al_2O_3$ are grown on a single crystalline silicon substrate with

5

$Sb_2O_3$ as an oxygen source. A temperature of an Al cell (4a in FIG. 2) was held constant at 1,100ºC, that of a Mg cell (4b in FIG. 2) constant at 350ºC, and a pressure of $As_2O_3$ constant 3.3 x $10^{-6}$ Pa (2.5 x $10^{-8}$ Torr).

FIG. 4-1 shows the results of the growth of $MgO \cdot Al_2O_3$ in the case where a temperature of the single crystalline silicon substrate is held at 800ºC. A streaked pattern proving a single crystalline structure was obtained.

FIG. 4-2 shows the results of the same in the case where a temperature of the single crystalline silicon substrate is held at 700ºC. A ringed pattern proving a poly crystalline structure was obtained.

In addition, FIG. 4-3 shows the results of the same in case where a temperature of the substrate is held at 500ºC. A hollow pattern proving an amorphous structure was obtained.

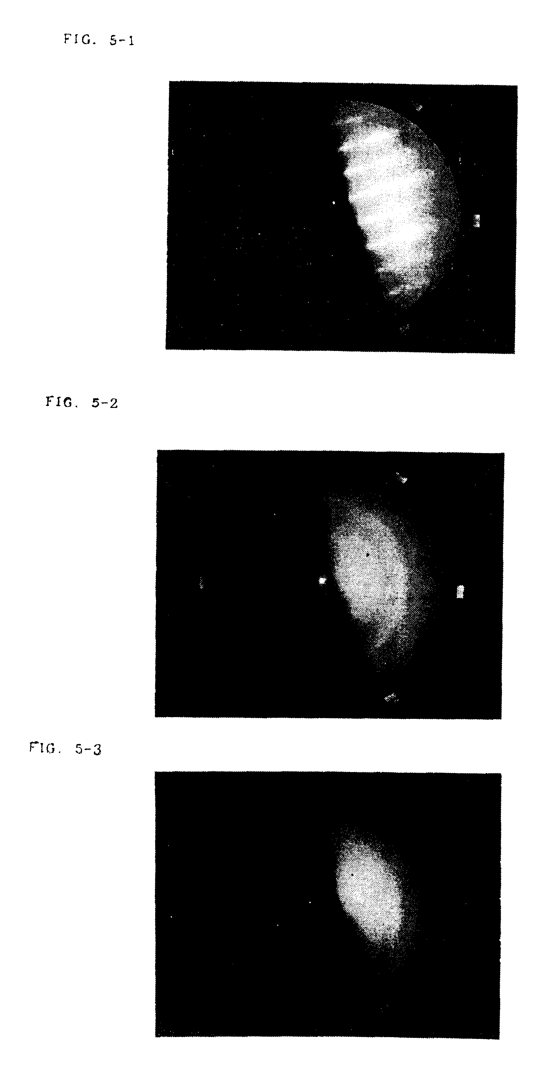

RHEED patterns as shown in FIGS. 5-1 to 3 show the differences in crystallinity in case where the crystals of $MgO \cdot Al_2O_3$ are grown on a single crystalline silicon substrate with $As_2O_3$ as an oxygen source. Excepting that a pressure of $As_2O_3$ was 3.7 x $10^{-6}$ Pa (2.8 x $10^{-8}$ Torr) constant, the conditions were same as in case where $Sb_2O_3$ was used as an oxygen source. Accordingly, at the substrate temperature 800ºC a streaked pattern proving a single crystalline structure was obtained as shown in FIG. 5-1, at the substrate temperature 700ºC a ringed pattern proving a poly crystalline structure as shown in FIG. 5-2, at the substrate temperature 500ºC a hollow pattern proving an amorphous structure as shown in FIG. 5-3.

Although it is a matter of course that the crystallinity is different depending upon the kinds of substances of oxide films to be formed on a single crystalline silicon substrate, as described above, a single crystalline layer is obtained at the substrate temperature of 900ºC or less but over a certain temperature to protect a silicon substrate and semiconductor elements formed thereon.

(2) Ratio of atom numbers

It has been concluded that the ratios of a number of metal atoms, such as Al, Mg and Al + Mg, which construct molecules of the substances of oxide films, to an oxygen atom are preferably 2 to 4 regardless of the kinds of the substances of oxide films. An amorphous oxide film is formed in case where a ratio of a number of oxygen atoms to a number of metal atoms is less than 2, and one or some bonds of a metal atom are not linked with oxygen atoms, so that the formed oxide film becomes short of oxygen, thereby optical- and electronic characteristics are deteriorated. On the contrary, in the case where a ratio of a number of oxygen atoms to a number of metal atoms exceeds 4, a poly crystalline film is formed or the crystal is insufficiently grown, and further, oxygen atoms act upon Si atoms of a silicon substrate faster than upon metal atoms to form an amorphous $SiO_2$ film in some cases. An insulating film is no longer grown on this amorphous $SiO_2$ film in an epitaxial manner.

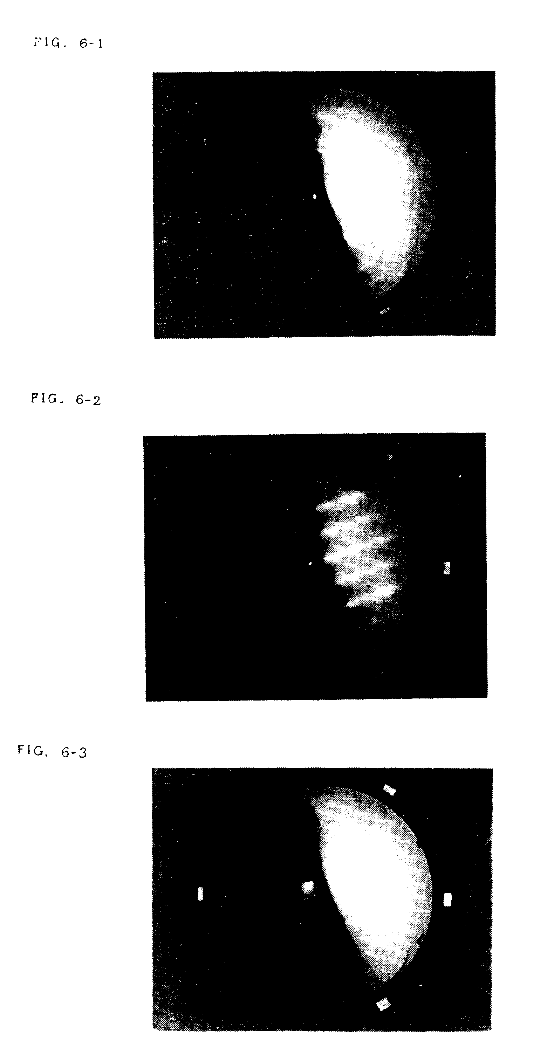

FIG. 6-1 to 3 show the relations between pressures of $Sb_2O_3$ and the crystallinity of the formed oxide film of $MgO \cdot Al_2O_3$ grown on a single crystalline silicon substrate at the constant substrate temperature of 800ºC with $Sb_2O_3$ as an oxygen source. The temperatures of an Al cell and a Mg cell were held constant (1,100ºC and 350ºC). In other words, the number of Al atoms and Mg atoms supplied was held constant but the number of oxygen atoms supplied was varied.

FIG. 6-1 shows a RHEED pattern of a $MgO \cdot Al_2O_3$ film formed in case where a pressure of $Sb_2O_3$ is high to an extent of 1.3 x $10^{-5}$ Pa (1 x $10^{-7}$ Torr), in other words a ratio of a number of oxygen atoms to a number of metal atoms is large. A ringed pattern proving a poly crystalline structure was obtained.

FIG. 6-2 shows a RHEED pattern of a $MgO \cdot Al_2O_3$ film formed in case where a pressure of $Sb_2O_3$ is 3.3 x $10^{-6}$ Pa (2.5 x $10^{-8}$ Torr) (the optimum condition), in other words a ratio of a number of oxygen atoms to a number of metal atoms is 2 to 4. A streaked pattern proving a single crystalline structure was obtained.

FIG. 6-3 shows a RHEED pattern of a $MgO \cdot Al_2O_3$ film formed in case where a pressure of $Sb_2O_3$ is low to an extent of 1.3 x $10^{-6}$ Pa (1.0 x $10^{-8}$ Torr), in other words a ratio of a number of oxygen atoms to a number of metal atoms is small. A hollow pattern proving an amorphous structure was obtained.

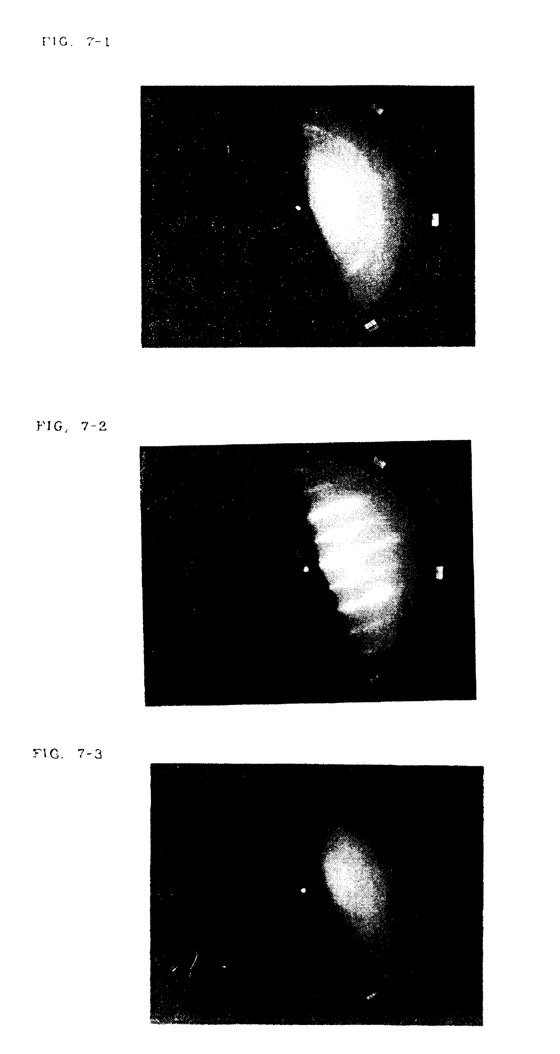

FIGS. 7-1 to 3 show RHEED patterns of $MgO \cdot Al_2O_3$ grown on a single crystalline silicon substrate similarly to the above described with $As_2O_3$ as an oxygen source. Similarly to the above described, a substrate temperature was 800ºC, a temperature of an Al cell 1,100ºC, and a temperature of a Mg cell 350ºC. And, a ringed pattern proving a poly crystalline structure was obtained as FIG. 7-1 showing a RHEED pattern of a $MgO \cdot Al_2O_3$ film formed in case where a ratio of a number of oxygen atoms to a number of metal atoms is large and a pressure of $As_2O_3$ is 1.3 x $10^{-5}$ Pa (1 x $10^{-7}$ Torr). A streaked pattern proving a single crystalline structure was obtained as FIG. 7-2 showing a RHEED pattern of a $MgO \cdot Al_2O_3$ film formed in case where a ratio of a number of oxygen atoms to a number of metal atoms is 2 to 4 and a pressure of $As_2O_3$ is 3.7 x $10^{-6}$ Pa (2.8 x $10^{-8}$ Torr). A hollow pattern proving an amorphous structure was obtained as FIG. 7-3 showing a RHEED pattern of a $MgO \cdot Al_2O_3$ film formed in case where a ratio of a number of oxygen atoms to a number of metal atoms is small and a pressure of $As_2O_3$ is 1.3 x $10^{-6}$ Pa (1.0 x $10^{-8}$ Torr).

As described above, in case where a ratio of a number of oxygen atoms to a number of metal atoms constructing a molecule of an oxide film is 2 to 4 in dependence upon an oxygen source, a single crystalline oxide film of metals such as Al, Mg and Al + Mg can be formed on a single crystalline silicon substrate.

(3) Film-growth speed

Every oxide film of $Al_2O_3$, MgO and $MgO \cdot Al_2O_3$ was formed at a film-growth speed of 0.1 to 2.0 $\mu$m/hour. The crystals are difficult to grow at a film-growth speed of 0.1 $\mu$m/hour or less, and poly crystals are formed at a film-growth speed of 2.0 $\mu$m/hour or more. The reason of the above described is that new molecules deposit to a crystal before the crystal grows in the form of a single crystal, thereby forming a poly crystal in case where the film-growth speed exceeds 2.0 $\mu$m/hour.

In addition, the Al cell temperature and the Mg cell temperature as shown in Table 1 determine the number of Al atoms and Mg atoms supplied from the effusing cells 4a, 4b, respectively. On the other hand, the pressure of $Sb_2O_3$ as shown in Table 1 is determined by the temperature of the effusing cell 4c and determines the number of oxygen atoms to be supplied. Accordingly, although such a relation that the ratio of the number of oxygen atoms to the number of metal atoms may be 2 to 4 so as to obtain a single crystalline film exists between these numerical values, fundamentally at first a pressure of $Sb_2O_3$ is set at 2.7 x $10^{-6}$, 2.7 x $10^{-5}$ and 3.3 x $10^{-6}$ Pa, (2.0 x $10^{-8}$, 2.0 x $10^{-7}$ and 2.5 x $10^{-8}$ Torr) for $Al_2O_3$, MgO and $MgO \cdot Al_2O_3$, respectively, on the basis of a vacuum condition within a ultra-high vacuum vessel 1 and then a temperature of each of the effusing cells 4a, 4b and 4c is determined so that a ratio of a number of oxygen atoms to a number of metal atoms may be 2 to 4 in dependence upon the pressure of $Sb_2O_3$.

Generally speaking, it is necessary only to set temperatures of substrate at 750ºC or more, 700ºC or more and 800ºC or more (but 900ºC or less in order to protect a substrate and a device), respectively, in order to grow a single crystalline oxide film such as $Al_2O_3$, MgO or $MgO \cdot Al_2O_3$, which are oxides of a metal such as Al, Mg or Mg + Al, on a single crystalline silicon substrate, a pressure of $Sb_2O_3$ at 2.7 x $10^{-6}$, 2.7 x $10^{-5}$ and 3.3 x $10^{-6}$ Pa, (2.0 x $10^{-8}$, 2.0 x $10^{-7}$ and 2.5 x $10^{-8}$ Torr), respectively, a temperature of an Al cell at 1,100ºC in either case of $Al_2O_3$ or $MgO \cdot Al_2O_3$, a temperature of a Mg cell at 550ºC for MgO and 350ºC for $MgO \cdot Al_2O_3$, a ratio of a number of oxygen atoms to a number of metal atoms at 2 to 4, and a crystal-growth speed at 0.1 to 2.0 $\mu$m/hour.

## Claims

1. A method of producing a semiconductor device, in which an oxide film formed by oxidizing metal atoms with one or more group V metal oxides as an oxygen source is grown on a single crystalline silicon substrate by the Molecular Beam Epitaxy (MBE) technique, said oxide film being composed of a material selected from the group consisting of $MgO \cdot Al_2O_3$, MgO and $Al_2O_3$, characterised in that (1) the temperature of said single crystalline silicon substrate is set within the range of from 700ºC to 900ºC, said temperature being in the range of from 800°C to 900°C for an oxide film of $MgO \cdot Al_2O_3$; from 700°C to 900°C for an oxide film of MgO; and 750°C to 900°C for an oxide film of $Al_2O_3$, (2) the ratio of the number of oxygen atoms to the number of metal atoms supplied is set in the range of from 2:1 to 4:1, and (3) the crystal growth speed is set in the range of from 0.1 $\mu$m/hour to 2.0 $\mu$m/hour, whereby said oxide film is grown in a single crystalline form.

2. A semiconductor device, characterised in that layers of a single crystalline oxide film of a material selected from the group consisting of $MgO \cdot Al_2O_3$, MgO and $Al_2O_3$ and of single crystalline silicon material are alternately laminated onto a single crystalline silicon substrate to form a three-dimensional circuit structure in which all of the layers are of a single crystalline form wherein the oxide films are grown using the method of claim 1.

## Revendications

1. Procédé de fabrication d'un dispositif semiconducteur, dans lequel un film d'oxyde, formé par oxydation d'atomes de métal avec un ou plusieurs oxydes de métaux du groupe V comme source d'oxygène, est engendré sur un substrat de silicium monocristallin par la technique d'Epitaxie par Faisceau Moléculaire (MBE), le dit film d'oxyde étant composé d'une matière choisie dans le groupe

consistant en MgO.Al$_2$O$_3$ , MgO et Al$_2$O$_3$ , caractérisé en ce que (1) la température dudit substrat de silicium monocristallin est fixée dans la plage de 700°C à 900°C,ladite température étant dans la plage de 800°C à 900°C pour un film d'oxyde de MgO.Al$_2$O$_3$, de 700°C à 900°C pour un film d'oxyde de MgO, et de 750°C à 900°C pour un film d'oxyde de Al$_2$O$_3$ ; (2) le rapport du nombre d'atomes d'oxygène au nombre d'atomes de métal fournis est fixé dans la plage de 2:1 à 4:1 ; et (3) la vitesse de croissance du cristal est fixée dans la plage de 0,1 $\mu$m/heure à 2,0 $\mu$m/heure, de sorte que ledit film d'oxyde est produit sous une forme monocristalline.

**2.** Dispositif semi-conducteur, caractérisé en ce que des couches d'un film d'oxyde monocristallin, en une matière choisie dans le groupe comprenant MgO.Al$_2$O$_3$, MgO et Al$_2$O$_3$ , et de silicium monocristallin sont alternativement stratifiées sur un substrat de silicium monocristallin pour former une structure de circuit tridimensionnelle dans laquelle toutes les couches sont sous une forme monocristalline, les films d'oxyde étant engendrés par le procédé selon la revendication 1.

**Patentansprüche**

**1.** Verfahren zur Herstellung einer Halbleiter-Vorrichtung, bei dem ein Oxid-Film, der durch Oxidieren von Metall-Atomen mit einem oder mehreren Oxiden von Metallen der Gruppe V als Sauerstoff-Quelle gebildet worden ist, auf einem einkristallinen Silicium-Substrat mittels der Technik der Molekularstrahl-Epitaxie (MBE) zum Wachsen gebracht wird, wobei der Oxid-Film aus einem Material aufgebaut ist, das aus der aus MgO•Al$_2$O$_3$, MgO und Al$_2$O$_3$ ausgewählt ist,
dadurch gekennzeichnet, daß
(1) die Temperatur des einkristallinen Silicium-Substrats innerhalb des Bereichs von 700 °C bis 900 °C festgelegt wird, wobei die Temperatur für einen Oxid-Film aus MgO•Al$_2$O$_3$ im Bereich von 800 °C bis 900 °C liegt, für einen Oxid-Film aus MgO im Bereich von 700 °C bis 900 °C liegt und für einen Oxid-Film aus Al$_2$O$_3$ im Bereich von 750 °C bis 900 °C liegt,
(2) das Verhältnis der Zahl der Sauerstoff-Atome zu der Zahl der zugeführten Metall-Atome in dem Bereich von 2 : 1 bis 4 : 1 festgelegt wird, und
(3) das Kristallwachstum auf einen Wert im Bereich von 0,1 $\mu$m/h bis 2,0 $\mu$m/h eingestellt wird,
wodurch der Oxid-Film in Form eines Einkristalls zum Wachsen gebracht wird.

**2.** Halbleiter-Vorrichtung, dadurch gekennzeichnet, daß Schichten aus einem einkristallinen Oxid-Film aus einem aus der aus MgO•Al$_2$O$_3$, MgO und Al$_2$O$_3$ bestehenden Gruppe ausgewählten Material und einem einkristallinen Silicium-Material alternierend auf ein einkristallines Silicium-Substrat laminiert werden, wodurch eine Struktur einer dreidimensionalen Schaltung gebildet wird, in der sämtliche Schichten die Form von Einkristallen haben, wobei die Oxid-Filme mittels des Verfahrens nach Anspruch 1 zum Wachsen gebracht werden.

FIG. 1

FIG. 2

FIG. 3

FIG. 4-1

FIG. 4-2

FIG. 4-3

FIG. 5-1

FIG. 5-2

FIG. 5-3

FIG. 6-1

FIG. 6-2

FIG. 6-3

FIG. 7-1

FIG. 7-2

FIG. 7-3